# EUROPEAN PATENT SPECIFICATION

(11) **EP 3 809 811 B1**
(45) Date of publication and mention of the grant of the patent: **29.07.2026**
(21) Application number: 18922570.9
(22) Date of filing: 12.06.2018
(51) Int. Cl.: H05K 13/08

(54) **COMPONENT MOUNTING MACHINE AND COMPONENT MOUNTING SYSTEM**
KOMPONENTENMONTAGEMASCHINE UND KOMPONENTENMONTAGESYSTEM
MACHINE DE MONTAGE DE COMPOSANT ET SYSTÈME DE MONTAGE DE COMPOSANT

(43) Date of publication of application: 21.04.2021
(73) Proprietor: Fuji Corporation, Chiryu-shi, Aichi 472-8686 (JP)
(72) Inventor: AOU Hiroyuki, Chiryu-shi, Aichi 472-8686 (JP)
(74) Representative: Grünecker Patent- und Rechtsanwälte PartG mbB
(86) International application number: PCT/JP2018/022421
(87) International publication number: WO 2019/239485

(56) References cited:
- EP-A1- 3 229 091
- WO-A1-2016/088266
- JP-A- 2004 070 917
- JP-A- 2004 070 917
- JP-A- 2007 335 711
- JP-A- 2007 335 711
- JP-A- 2017 220 624

## Description

### Technical Field

The technique disclosed in the present specification relates to a component mounting machine and a component mounting system for mounting electronic components on a board.

### Background Art

For example, JP-A-2012-248815 discloses an example of a component mounting machine for mounting electronic components on a board. In some such component mounting machines, it is possible to set operating conditions of a mounting process executed by the component mounting machine. For each operator of the component mounting machine, the work content (that is, the work authority of) the operator can execute differs. Therefore, this type of component mounting machine includes an authentication section for authenticating an operator. In the component mounting machine, when the operator authenticated by the authentication section has the work authority, the work performed by the operator is made valid. In general, the authentication section uses passwords to authenticate operators.

EP 3229091A1 relates to a work management device. For each work item, an operator is assigned and for each operator, physical features are stored. When an operator approaches a machine, the machine identifies the operator based on their physical features and the work items associated with said operator are shown to the operator.

### Summary of the Invention

### Technical Problem

As described above, in the conventional component mounting machine, the operator is authenticated using a password. However, in password authentication, each time work is performed, a password is to be input by the operator. Therefore, an input operation by the operator is necessary every time the work is performed, resulting in a problem that the workload is great. The present specification discloses a technique for facilitating authentication of an operator in a component mounting machine.

### Solution to Problem

The invention is defined by the features of the independent claims. Any reference to inventions or embodiments not falling within the scope of the independent claims are to be interpreted as examples useful for understanding the invention.

The component mounting machine disclosed in the present specification mounts electronic components on a board. A component mounting machine for mounting a component on a board, including a component mounting section configured to execute a mounting process of mounting the electronic component on the board, a work content storage section configured to store, for each operator, a physical feature acquired from the operator in association with work content executable by the operator, a first physical feature acquisition section configured to acquire the physical feature from the operator, and a work content determining section configured to, in a case in which work is performed on the component mounting section from the operator, validate the work performed by the operator when the work performed by the operator is stored in the work content storage section as the work content associated with the physical feature of the operator acquired by the first physical feature acquisition section, while configured to void the work performed by the operator when the work performed by the operator is not stored in the work content storage section as the work content associated with the physical feature of the operator acquired by the first physical feature acquisition section.

The component mounting machine described above relies on the physical feature (for example, a fingerprint, an iris, the face, or the like) for authenticating the operator as an appropriate operator, which does not require a procedure (for example, an input operation such a password input). Therefore, the operator can easily authenticate with the component mounting machine. The work performed by an operator who is not an appropriate operator is voided in the work content determining section. Therefore, it is possible to ensure the appropriate operation of the component mounting machine.

The component mounting system disclosed in the present specification includes a component mounting line including the multiple component mounting machines, and a management device communicably connected to the multiple component mounting machines and managing the component mounting line. The management device includes a second physical feature acquisition section configured to acquire the physical feature of an operator, a work content setting section configured to set, for the operator having the physical feature acquired by the second physical feature acquisition section, work content executable by the operator, and a transmission section configured to transmit management information, which is set by the work content setting section and in which the physical feature is associated with the executable work content, to the multiple component mounting machines. The multiple component mounting machines update information stored in the work content storage section of the component mounting machine when the management information is received from the transmission section of the management device.

In the component mounting system, management information, in which the physical feature of the operator is associated with the work content executable by the operator, is transmitted from the management device to multiple component mounting machines. Therefore, it is possible for each component mounting machine to eliminate the need of the setting work.

### Brief Description of Drawings

Fig. 1 is a diagram illustrating a schematic configuration of a component mounting system according to an embodiment.
Fig. 2 is a diagram illustrating a schematic configuration of a component mounting machine.
Fig. 3 is a sectional view taken along a line III-III of Fig. 2.
Fig. 4 is a block diagram illustrating the functions of a control device of the component mounting machine.
Fig. 5 is a block diagram illustrating the functions of an arithmetic unit of a management device.
Fig. 6 is a flowchart illustrating an example of processes in which the arithmetic unit sets the work authority of an operator in the management device.
Fig. 7 is a flowchart illustrating an example of processes in which the control device receives the work of the operator in the component mounting machine.

### Description of Embodiments

The main features of the embodiment are listed below. The technical elements described below are independent technical elements, exhibit technical usefulness independently or in various combinations thereof, and are not limited to the combinations described in the claims at the time of filing.

In the component mounting machine disclosed in the present specification, the work content storage section may include a first storage portion configured, for each operator, to store the physical feature acquired from the operator in association with a type of a work authority assigned to the operator, and a second storage portion configured to store the work content executable with the type of the work authority for each type of the work authority. In a case in which work is performed on the component mounting section from the operator, the work content determining section may specify the type of the work authority associated with the physical feature of the operator from information stored in the first storage portion and may specify the work content executable with the type of the specified work authority from information stored in the second storage portion. With such a configuration, by setting the type of the work authority for each operator, it is possible to appropriately manage the range of the executable work content according to the capabilities and skills of the operator.

In the component mounting machine disclosed in the present specification, the work content storage section may store, as being executable, setting work for setting operating conditions of the mounting process to be executed by the component mounting section in association with a physical feature acquired from a specific operator. The work content determining section may validate the setting work when the setting work is performed by the specified operator and may void the setting work when a person other than the specified operator performs the setting work. With such a configuration, since the setting of the work conditions by the operator who does not have the authority is voided, it is possible to enhance the security for the setting of the work conditions.

The component mounting machine disclosed in the present specification may further include a notification section configured to issue a notification when the work performed by the operator is voided by the work content determining section. With such a configuration, the notification section issues a notification of the fact that the work performed by a person who is not an appropriate operator has been voided. Therefore, it is possible to prompt an appropriate operator to perform the work.

In the component mounting machine disclosed in the present specification, the notification section may issue the notification to the operator capable of executing the work that is voided by the work content determining section. With such a configuration, it is possible to swiftly perform the work of an appropriate operator.

In the component mounting system disclosed in the present specification, the management device may further include a management information determining section configured to validate the management information set by the work content setting section when the management information is set by a manager having a specific authority, and void the management information when the management information is set by a person other than the manager having the specific authority. The transmission section may transmit the management information to the multiple component mounting machines when the management information is determined to be valid by the management information determining section. With such a configuration, since the setting work by the manager who does not have a specific authority is voided, it is possible to enhance the security for the setting of the authentication information of the operator.

**In** the component mounting system disclosed in the present specification, the management device may further include a management information storage section configured to store the management information in association with the manager who has set the management information when the management information determining section determines that the management information is valid. With such a configuration, by storing the manager who sets the management information in the management device, it is possible to improve the traceability of the management information and to appropriately manage the management information.

### Embodiment

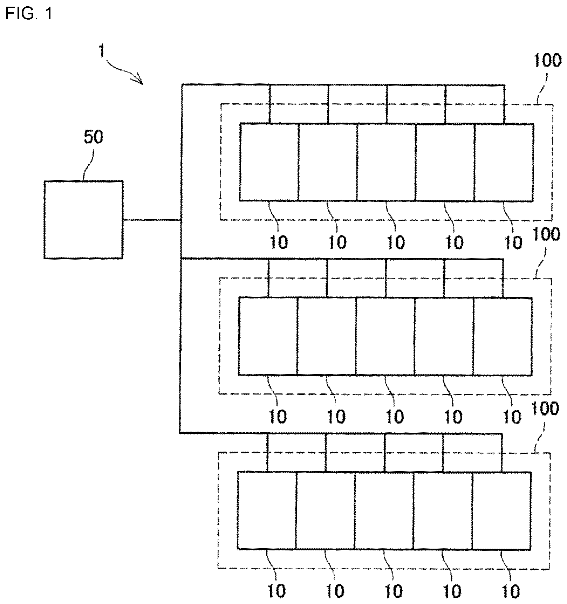

Hereinafter, component mounting system 1 according to the embodiment will be described. As illustrated in Fig. 1, component mounting system 1 includes management device 50 and multiple component mounting lines 100. Each of the multiple component mounting lines 100 includes multiple component mounting machines 10. Each of the multiple component mounting machines 10 is communicably connected to management device 50. Management device 50 manages multiple component mounting lines 100 (that is, multiple component mounting machines 10 provided in each of the multiple component mounting lines 100). For example, in Fig. 1, component mounting line 100 includes five component mounting machines 10, and management device 50 manages 15 component mounting machines 10. The number of component mounting machines 10 included in one component mounting line 100 is not limited to the above, and the number of component mounting lines 100 managed by management device 50 is also not limited to the above.

Component mounting machine 10 mounts electronic components 4 on circuit board 2. Circuit board 2 is sent from a first end of component mounting line 100 toward a second end. In each component mounting machine 10 electronic components 4 determined in advance are mounted to circuit board 2. Circuit board 2 sent to the second end of component mounting line 100 is shipped as a final product or is sent to a later step as a semi-finished product. It is possible to install multiple component feeders 12 on component mounting machine 10. By installing component feeders 12 on component mounting machine 10, electronic components 4 are supplied to component mounting machine 10 from component feeders 12. In component mounting line 100, it is possible to install component feeders 12 on any of multiple component mounting machines 10. Which type of component feeder 12 is installed on component mounting machine 10 is determined in management device 50.

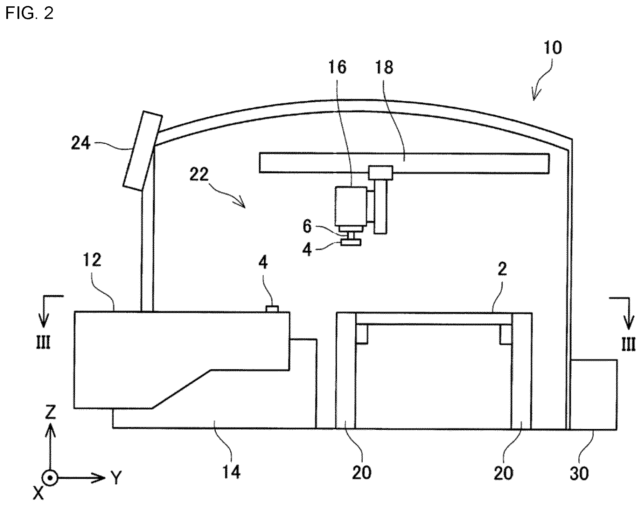

Here, the configuration of component mounting machine 10 will be described. As illustrated in Figs. 2 to 4, component mounting machine 10 includes component mounting section 22, interface device 24, identification information acquisition section 26, transmission and reception section 28, and control device 30.

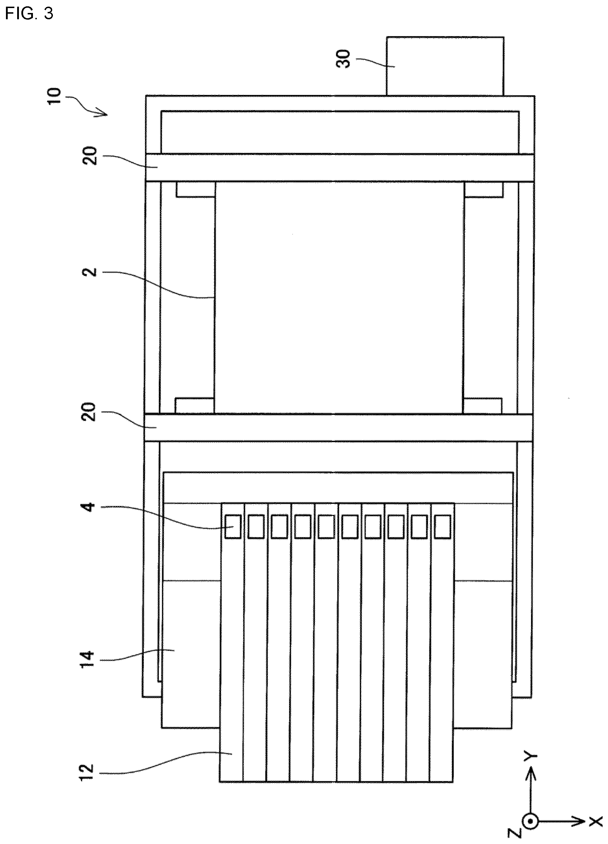

As illustrated in Figs. 2 and 3, component mounting section 22 includes multiple component feeders 12, feeder holding section 14, mounting head 16, head moving device 18, and board conveyor 20. Each component feeder 12 accommodates multiple electronic components 4. Component feeder 12 is detachably attached to feeder holding section 14 and supplies electronic components 4 to mounting head 16. The specific configuration of component feeder 12 is not particularly limited. Each component feeder 12, for example, may be any of a tape-type feeder for accommodating multiple electronic components 4 on a wound tape, a tray-type feeder for accommodating multiple electronic components 4 on a tray, or a bulk-type feeder for accommodating multiple electronic components 4 randomly in a container.

Feeder holding section 14 includes multiple slots, and it is possible to detachably install component feeder 12 in each of the multiple slots. Feeder holding section 14 may be fixed to component mounting machine 10 or may be detachably attached to component mounting machine 10. Mounting head 16 detachably holds one or multiple suction nozzles 6, uses suction nozzle 6 to pick up electronic component 4 supplied by component feeder 12, and mounts electronic component 4 on circuit board 2. At this time, head moving device 18 moves mounting head 16 with respect to component feeder 12 and circuit board 2. Accordingly, electronic component 4 is picked up from a specific component feeder 12 of multiple component feeders 12, and electronic component 4 is mounted on circuit board 2 at a position determined in advance. Board conveyor 20 carries in, supports, and carries out circuit board 2.

Identification information acquisition section 26 acquires, from the operator, information relating to the physical feature of the operator (hereinafter also referred to as the identification information). The identification information is used to identify the operator, and the type of the identification information is not particularly limited. For example, the identification information may be a fingerprint of the operator, or may be an iris, the face, or the like of the operator. Identification information acquisition section 26 is configured to be capable of acquiring the identification information. For example, in the present embodiment, the identification information is a fingerprint of each operator, and identification information acquisition section 26 is a fingerprint sensor. When the identification information is an iris, the face, or the like of each operator, identification information acquisition section 26 is a camera configured to be capable of photographing an iris, a face, or the like. Identification information acquisition section 26 is connected to control device 30, and the identification information input to identification information acquisition section 26 is input to control device 30. By using the information relating to the physical feature of the operator as the identification information, a procedure for identifying the operator (for example, an input operation such as the input of a password) is not necessary. Therefore, it is possible to facilitate the procedure for identifying the operator. Identification information acquisition section 26 is an example of a "first physical feature acquisition section".

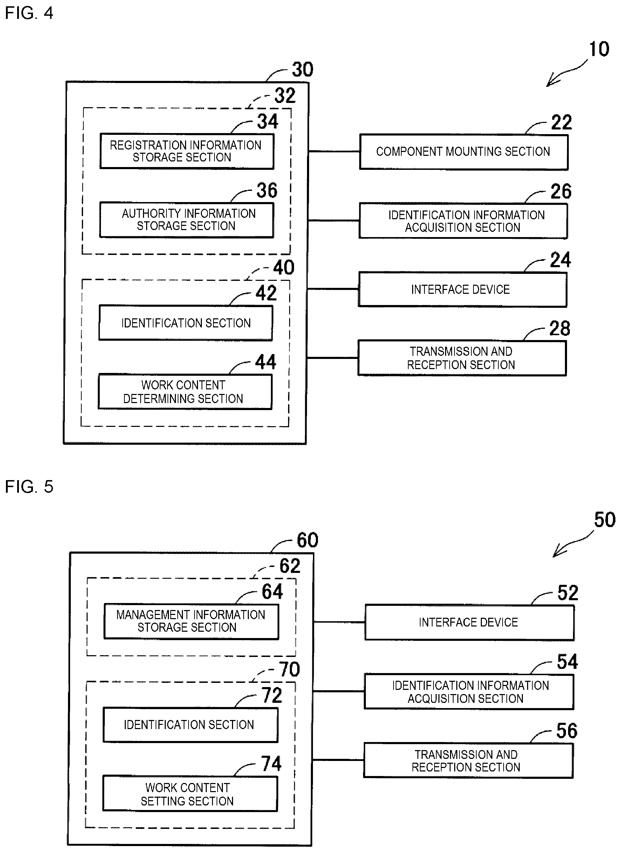

As illustrated in Fig. 4, control device 30 is configured using a computer including memory 32 and CPU 40. Memory 32 is provided with registration information storage section 34 and authority information storage section 36.

Registration information storage section 34 stores information relating to operators registered in advance. In the present embodiment, registration information storage section 34 stores information relating to fingerprints of each operator as the identification information for identifying the operators. Registration information storage section 34 stores the identification information (for example, information relating to a fingerprint of each operator in the present embodiment) in combination with the work authority permitted to the operator. Hereinafter, the combination of the identification information and the work authority may be referred to as "management information". The management information is registered by management device 50, and is transmitted from management device 50 to the respective transmission and reception section 28 of each component mounting machine 10 configuring component mounting line 100. Transmission and reception section 28 outputs the received management information to control device 30, and control device 30 stores the management information input from transmission and reception section 28 in registration information storage section 34. Registration information storage section 34 is an example of the "first storage portion".

Authority information storage section 36 stores a combination of the type of the work authority assigned to each operator and the work content executable by the operator by the type of the work authority. Specifically, authority information storage section 36 stores, for each type of work authority, a setting range of work conditions that can be input by an operator having the work authority. Authority information storage section 36 stores multiple types of work authority. The types of work authority stored in authority information storage section 36 are not particularly limited, but in the present embodiment, three types of work authority are stored: operator authority, engineer authority, and manager authority.

The operator authority is the authority to perform auxiliary operations (for example, replenishment of components or tools) necessary when component mounting section 22 executes a mounting process. For example, when component feeder 12 has a component shortage, an operator having operator authority is capable of performing the work of replenishing component feeder 12 with electronic components 4. The engineer authority is the authority to change the settings relating to the production line in addition to the operator authority. For example, an operator having engineer authority is capable of changing the configuration of component mounting line 100. The manager authority is the authority to register and delete operators in addition to the engineer authority. For example, the operator having manager authority is capable of registering or deleting the management information of the operator (that is, the identification information of each operator (fingerprint of the operator in the present embodiment) and the work authority given to the operator). Hereinafter, operators having manager authority may be referred to as "managers". Authority information storage section 36 is an example of the "second storage portion".

In the present embodiment, registration information storage section 34 stores, for each operator, the identification information of the operator and the work authority permitted to the operator. As a result, it is possible to appropriately manage the range of work contents that can be executed by the operator in accordance with the capabilities and skills of the operator.

An operation program is stored in memory 32, and by CPU 40 executing the operation program, CPU 40 functions as identification section 42 and work content determining section 44.

Identification section 42 determines whether the identification information acquired by identification information acquisition section 26 is stored in registration information storage section 34.

Work content determining section 44 deconditionines whether the work conditions input by the operator are included in the setting range of the work authority assigned to the operator. In other words, when the work conditions are input from interface device 24, work content deconditionining section 44 specifies the work authority of the operator who operated interface device 24, and deconditionines whether the input work conditions fall within the range of the specified work authority. For example, when an operator having engineer authority inputs the work conditions for changing the settings of the production line, work content deconditionining section 44 deconditionines that the work conditions are included in the setting range of the work authority, whereas when an operator having operator authority inputs similar work conditions, work content deconditionining section 44 deconditionines that the work conditions are not included in the setting range of the work authority.

Interface device 24 is a display device that provides the operator with various types of information on component mounting machine 10 and is an input device that receives instructions and information from the operator. For example, when the work conditions input by the operator are outside the range of the work authority of the operator, interface device 24 displays a message notifying the operator of the fact. In the present embodiment, interface device 24 is a touch panel but is not limited to such a configuration. For example, interface device 24 may include a display device such as a display and an input device such as a keyboard and a mouse.

Transmission and reception section 28 transmits and receives information to and from management device 50. Specifically, transmission and reception section 28 receives the management information transmitted from management device 50 and transmits the fact to management device 50 when the work conditions input by the operator are outside the range of the work authority of the operator. Transmission and reception section 28 is connected by transmission and reception section 56 (described later) and a local area network (LAN) of management device 50. Transmission and reception section 28 and transmission and reception section 56 may be in any form as long as transmission and reception section 28 and transmission and reception section 56 are communicably connected, and may use a wired connection or a wireless connection, for example.

Next, the configuration of management device 50 will be described. As illustrated in Fig. 5, management device 50 includes interface device 52, identification information acquisition section 54, transmission and reception section 56, and arithmetic unit 60.

Interface device 52 is a display device that provides various types of information of management device 50 to an operator (in particular, a manager), and is an input device that receives instructions and information from the operator (in particular, the manager). For example, when transmission and reception section 56 receives the fact that the work conditions input by the operator in component mounting machine 10 are outside the range of the work authority of the operator, interface device 52 displays a message notifying the manager of this fact. In the present embodiment, interface device 52 is configured by a display device such as a display and an input device such as a keyboard and a mouse, but the configuration of interface device 52 is not particularly limited and may be, for example, a touch panel.

Identification information acquisition section 54 is configured to acquire the identification information from an operator, and is a fingerprint sensor in the present embodiment. Transmission and reception section 56 is configured to transmit and receive information to and from each component mounting machine 10, and specifically, transmission and reception section 28 transmits the management information to each component mounting machine 10 and receives information transmitted from each component mounting machine 10. Since the configurations of identification information acquisition section 54 and transmission and reception section 56 are substantially the same as those of identification information acquisition section 26 and transmission and reception section 28, the detailed description thereof will be omitted.

Arithmetic unit 60 is configured using a computer including memory 62 and CPU 70. Memory 62 is provided with management information storage section 64.

Management information storage section 64 stores a combination of the management information of the operator set by management device 50 (that is, the identification information of each operator (fingerprints of the operators in the present embodiment) and the work authority given to the operator), and the information relating to the manager for whom the management information is set. Information relating to the manager for whom the management information is set may be any information capable of specifying the manager, may be the identification information of the manager, or may be the ID, name, or the like of the manager.

An operation program is stored in memory 62, by CPU 70 executing the operation program, CPU 70 functions as identification section 72 and work content setting section 74.

Identification section 72 determines whether the identification information acquired by identification information acquisition section 54 is the identification information of the manager stored in management information storage section 64. That is, when the identification information acquired by identification information acquisition section 54 is stored in management information storage section 64 and the work authority stored in combination with the identification information is the manager authority, identification section 72 determines that the identification information is the identification information of the manager. On the other hand, identification section 72 determines that the identification information is not the identification information of the manager when the identification information acquired by identification information acquisition section 54 is not stored in management information storage section 64 or when the work authority stored in management information storage section 64 in combination with the identification information is not the manager authority (the operator authority or the engineer authority).

Work content setting section 74 sets the work authority for the identification information acquired by identification information acquisition section 54. As described above, the setting of the work authority for the operator is work that can be executed only by the manager. Therefore, work content setting section 74 is configured to acquire the identification information of the operator, and when identification section 72 determines the identification information to be the identification information of the manager, it is possible to set the work authority. The work authority set by work content setting section 74 is stored in management information storage section 64 together with the identification information of the corresponding operator and the information relating to the manager who sets the work authority.

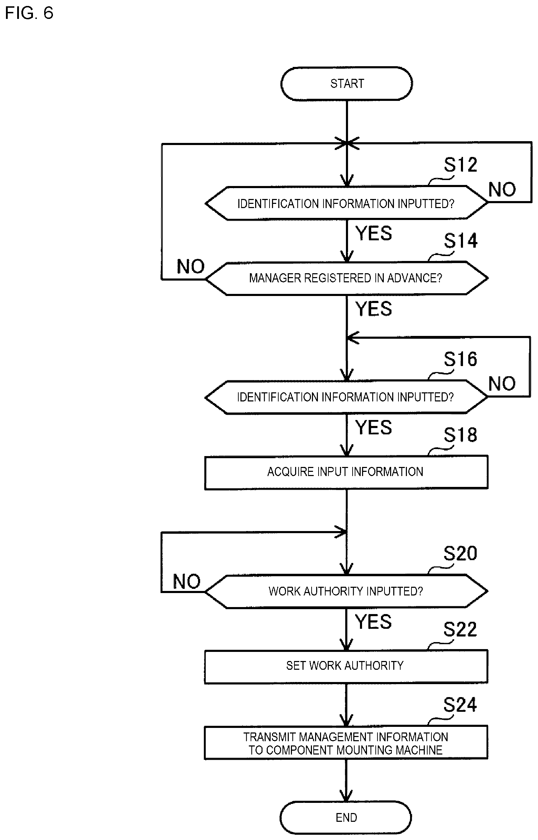

The process of setting the work authority for the operator by the manager will be described with reference to Fig. 6. The work authority of each operator is set by the manager using management device 50. The management information set by management device 50 (the identification information and the work authority of the operator) is transmitted to each component mounting machine 10. Accordingly, it is possible to omit the work of setting the work authority of the same operator in each of multiple component mounting machines 10. Hereinafter, a process in which arithmetic unit 60 sets the work authority for the operator using management device 50 will be described.

As illustrated in Fig. 6, first, arithmetic unit 60 determines whether the identification information has been inputted to identification information acquisition section 54 (S12). The manager inputs the identification information specifying the manager themselves to identification information acquisition section 54. In the present embodiment, since identification information acquisition section 54 is a fingerprint sensor, the manager causes identification information acquisition section 54 to read the fingerprint of the manager themselves. Identification information acquisition section 54 outputs the acquired identification information (information related to the read fingerprint of the manager) to arithmetic unit 60. If the identification information has not been inputted from identification information acquisition section 54 (NO in step S12), arithmetic unit 60 waits until the identification information is input from identification information acquisition section 54.

When the identification information has been inputted from identification information acquisition section 54 (YES in step S12), identification section 42 determines whether the operator related to the identification information input in step S12 is a manager who has been registered in advance (S14). That is, identification section 42 determines whether the identification information input in step S12 is stored in management information storage section 64. When the input identification information is stored in management information storage section 64, it is determined whether the work authority stored in combination with the identification information is the manager authority. That is, it is determined whether the input identification information is stored in management information storage section 64 in association with manager authority. Specifically, when the identification information input in step S12 is stored in management information storage section 64 and the work authority stored in combination with the identification information is the manager authority, identification section 72 determines that the input identification information is stored in management information storage section 64 in association with the manager authority. On the other hand, when the identification information input in step S12 is not stored in management information storage section 64 or when the input identification information is stored in management information storage section 64 but the work authority stored in combination with the identification information is not the manager authority (that is, when the work authority is the operator authority or the engineer authority), identification section 72 determines that the input identification information is not stored in management information storage section 64 in association with the manager authority.

When the identification information input in step S12 is not stored as a manager in management information storage section 64 (NO in step S14), it is determined that the operator does not have the manager authority and the setting of the work authority by the operator is denied. Therefore, the process returns to step S12, and the process is repeated from step S12.

When the identification information input in step S12 is stored as a manager in management information storage section 64 (YES in step S14), it is determined that the manager is a manager having manager authority, and the setting of work authority for another operator by the manager is permitted. Arithmetic unit 60 determines whether the identification information has been inputted to identification information acquisition section 54 (S16). Here, an operator who sets the new management information and an operator who deletes the set management information input the identification information to identification information acquisition section 54. If the identification information has not been inputted from identification information acquisition section 54 (NO in step S16), arithmetic unit 60 waits until the identification information is input from identification information acquisition section 54. When the identification information is input from identification information acquisition section 54 (YES in step S16), arithmetic unit 60 acquires the identification information on the input operator (S18).

Next, arithmetic unit 60 determines whether the work authority to be set for the operator who has input the identification information in step S18 has been inputted to interface device 52 (S20). At this time, the input of the work authority to interface device 52 is executed by the manager who has input the identification information in step S12. When the work authority has not been inputted to interface device 52 (NO in step S20), arithmetic unit 60 waits until the work authority is input to interface device 52.

When the work authority is input to interface device 52 (NO in step S20), work content setting section 74 sets the input work authority in combination with the identification information acquired in step S18 (S22). The work authority corresponding to the set identification information is stored in management information storage section 64. At this time, management information storage section 64 stores the set identification information and the corresponding work authority in combination with information relating to the manager who has executed the input. That is, management information storage section 64 stores the identification information of the operator acquired in step S18, the work authority set for the operator, and the information relating to the manager acquired in step S12 in combination. Accordingly, it is possible to store which manager has set the management information and to improve the traceability of the management information. Therefore, it is possible to appropriately manage the management information.

When the management information is stored in management information storage section 64, arithmetic unit 60 transmits the management information stored in management information storage section 64 to each component mounting machine 10 via transmission and reception section 56 (S24). The management information transmitted from management device 50 is received by transmission and reception section 28 of each component mounting machine 10 and control device 30 of each component mounting machine 10 stores the received management information in registration information storage section 34. Accordingly, it is possible to store the management information set by management device 50 in each component mounting machine 10.

As described above, in management device 50, it is possible to set the work authority for the operator only when it is determined that the operator is a manager. In other words, an operator who does not have the manager authority is not able to set the work authority for the operator. Accordingly, it is possible to enhance the security for the setting of work authority.

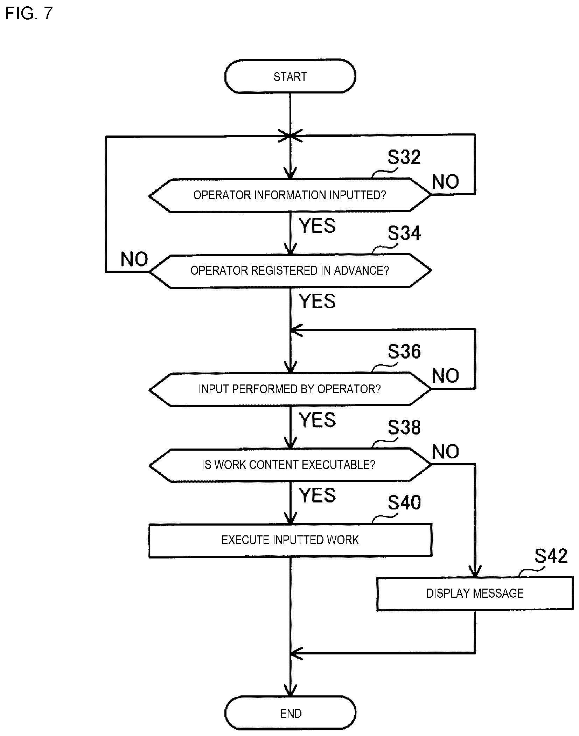

Next, with reference to Fig. 7, a description will be given of the processes of component mounting machine 10 when an operator executes work on component mounting machine 10. As illustrated in Fig. 7, first, control device 30 determines whether the identification information has been inputted to identification information acquisition section 26 (S32). The operator who intends to execute the work on component mounting machine 10 inputs the identification information (a fingerprint of the operator in the present embodiment) specifying the operator themselves to identification information acquisition section 26. Identification information acquisition section 26 outputs the acquired identification information to control device 30. When the identification information has not been inputted from identification information acquisition section 26 (NO in step S32), control device 30 waits until the identification information is input from identification information acquisition section 26.

When the identification information is input from identification information acquisition section 26 (YES in step S32), identification section 42 determines whether the operator related to the identification information input in step S12 is an operator who has been registered in advance (S34). That is, identification section 42 determines whether the identification information input in step S32 is stored in registration information storage section 34. When the identification information input in step S32 is not stored in registration information storage section 34 (NO in step S34), it is determined that the operator does not have the authority to execute the work on component mounting machine 10, and the work on component mounting machine 10 is denied. Therefore, the process returns to step S32, and the processes are repeated from step S32.

When the identification information input in step S32 is stored in registration information storage section 34 (YES in step S34), control device 30 deconditionines whether the work conditions have been inputted to component mounting machine 10 by the operator (S36). When the work conditions have not been inputted to component mounting machine 10 (NO in step S36), control device 30 waits until the work conditions have been inputted to component mounting machine 10.

When the work conditions are input to component mounting machine 10 (YES in step S36), work content determining section 44 deconditionines whether the input work conditions can be executed by the operator who has input the identification information in step S32. As described above, registration information storage section 34 stores the management information which is a combination of the identification information for identifying each operator (the fingerprint of the operator in the present embodiment) and the work authority permitted to the operator. Work content determining section 44 specifies the work authority corresponding to the identification information stored in registration information storage section 34 with respect to the identification information input in step S32. Work content determining section 44 deconditionines whether the work conditions input in step S36 are included in the work content executable with the specified work authority based on the information stored in authority information storage section 36.

When the work conditions input in step S36 are included in the work content executable with the specified work authority (YES in step S38), control device 30 executes the work according to the input work conditions (S40).

On the other hand, when the work conditions input in step S36 are not included in the work content executable with the specified work authority (NO in step S38), control device 30 deconditionines that the operator does not have the authority to execute the input work conditions, and denies the execution of the work conditions. Control device 30 displays the fact that the work is not executable on interface device 24 (S42). For example, interface device 24 displays a message such as "not authorized" or "call an authorized person". Accordingly, it is possible to notify the operator who intends to execute the work that it is not possible to execute the work because the operator is not authorized. Accordingly, it is possible to prompt work by an operator having appropriate work authority. In the present embodiment, a message such as "not authorized" is displayed on interface device 24, but it is sufficient to adopt a configuration in which it is possible to notify the operator of the fact that the authority to execute the work is not present and the phrasing to be displayed on interface device 24 is not particularly limited. The operator may be notified by a voice generator to issue a notification using a voice, or the operator may be notified by a warning sound such as an alarm.

In the present embodiment, the work is executed according to the input work conditions only when the work conditions input in step S36 are the work content executable with the work authority of the operator. That is, the work conditions input by a person who is not an appropriate operator are not executed. Therefore, it is possible to enhance the security with respect to the input of the work conditions and it is possible to appropriately perform the mounting process of component mounting machine 10.

In the present embodiment, when the input work conditions are not included in the work content executable with the work authority of the operator, the operator is notified of the fact, but the present invention is not limited to such a configuration. For example, when the input work conditions are not included in the work content executable with the work authority of the operator, control device 30 may transmit the fact to management device 50 and display a message to issue a notification of the fact on interface device 52 of management device 50. An operator having the appropriate work authority may carry a wireless communication terminal and information may be transmitted to the wireless communication terminal carried by the operator. Accordingly, the operator having the work authority (for example, the manager) is capable of swiftly executing the work.

The technical elements described in the present specification or the drawings exhibit technical usefulness independently or in various combinations In addition, the technology exemplified in the present specification or the drawings simultaneously achieves multiple purposes and has technical utility in achieving one of the objectives by itself.

## Claims

1. A component mounting system comprising a component mounting line including multiple component mounting machines, each of the multiple component mounting machines (10) for mounting a component on a board, comprising:
a component mounting section (22) configured to execute a mounting process of mounting the electronic component on the board;
a work content storage section (34) configured to store, for each operator, a physical feature acquired from the operator in association with work content executable by the operator;
a first physical feature acquisition section configured to acquire the physical feature from the operator;
a work content determining section (44) configured to, in a case in which work is performed on the component mounting section (22) from the operator, validate the work performed by the operator when the work performed by the operator is stored in the work content storage section (34) as the work content associated with the physical feature of the operator acquired by the first physical feature acquisition section, and void the work performed by the operator when the work performed by the operator is not stored in the work content storage section (34) as the work content associated with the physical feature of the operator acquired by the first physical feature acquisition section, wherein
the work content storage section (34) stores, as being executable, setting work for setting operating conditions of the mounting process to be executed by the component mounting section (22) in association with a physical feature acquired from a specific operator, and the work content determining section (44) validate the setting work when the setting work is performed by the specified operator and void the setting work when a person other than the specified operator performs the setting work; and
a management device communicably connected to the multiple component mounting machines (10) and managing the component mounting line, wherein
the management device includes
a second physical feature acquisition section configured to acquire a physical feature from an operator;
a work content setting section configured to set, for the operator having the physical feature acquired by the second physical feature acquisition section, work content executable by the operator; and
a transmission section configured to transmit management information, which is set by the work content setting section and in which the physical feature is associated with the executable work content, to the multiple component mounting machines (10), and
the multiple component mounting machines (10) update information stored in the work content storage section (34) of the component mounting machine (10) when the management information is received from the transmission section of the management device.

2. The component mounting system according to claim 1, wherein the management device further includes a management information determining section configured to validate the management information set by the work content setting section when the management information is set by a manager having a specific authority, and void the management information when the management information is set by a person other than the manager having the specific authority, and the transmission section transmits the management information to the multiple component mounting machines (10) when the management information is determined to be valid by the management information determining section.

3. The component mounting system according to claim 2, wherein the management device further includes a management information storage section configured to store the management information in association with the manager who has set the management information when the management information determining section determines that the management information is valid.

## Patentansprüche

1. System zum Montieren von Bauteilen, das eine Bauteil-Montagestraße umfasst, die mehrere Bauteil-Montagemaschinen einschließt, wobei jede der mehreren Bauteil-Montagemaschinen (10) dazu dient, ein Bauteil auf einer Platte zu montieren, umfassend:
einen Bauteil-Montageabschnitt (22), der so ausgeführt ist, dass er einen Montageprozess zum Montieren des elektronischen Bauteils auf der Platte durchführt;
einen Abschnitt (34) zum Speichern von Arbeitsinhalt, der so ausgeführt ist, dass er für jede Bedienungsperson ein physisches Merkmal speichert, das von der Bedienungsperson in Zusammenhang mit Arbeitsinhalt erfasst wird, der von der Bedienungsperson ausgeführt werden kann;
einen ersten Abschnitt für Erfassung eines physischen Merkmals, der so ausgeführt ist, dass er das physische Merkmal von der Bedienungsperson erfasst;
einen Abschnitt (44) zum Bestimmen von Arbeitsinhalt, der so ausgeführt ist, dass er, wenn Arbeit an dem Bauteil-Montageabschnitt (22) von der Bedienungsperson durchgeführt wird und die durch die Bedienungsperson durchgeführte Arbeit in dem Abschnitt (34) zum Speichern von Arbeitsinhalt gespeichert ist, die von der Bedienungsperson durchgeführte Arbeit als den Arbeitsinhalt bestätigt, der mit dem physischen Merkmal der Bedienungsperson zusammenhängt, das durch den ersten Abschnitt für Erfassung eines physischen Merkmals erfasst wird, und die durch die Bedienungsperson durchgeführte Arbeit nicht bestätigt, wenn die von der Bedienungsperson durchgeführte Arbeit in dem Abschnitt (34) zum Speichern von Arbeitsinhalt nicht als der Arbeitsinhalt gespeichert ist, der mit dem physischen Merkmal der Bedienungsperson zusammenhängt, das durch den ersten Abschnitt für Erfassung eines physischen Merkmals erfasst wird, wobei
der Abschnitt (34) zum Speichern von Arbeitsinhalt als ausführbar Einstellarbeit zum Einstellen von Betriebsbedingungen des durch den Bauteil-Montageabschnitt (22) auszuführenden Montageprozesses im Zusammenhang mit einem von einer bestimmten Bedienungsperson erfassten physischen Merkmal speichert, und der Abschnitt (44) zum Bestimmen von Arbeitsinhalt die Einstellarbeit bestätigt, wenn die Einstellarbeit durch die bestimmte Bedienungsperson durchgeführt wird, und die Einstellarbeit nicht bestätigt, wenn eine andere Person als die bestimmte Bedienungsperson die Einstellarbeit durchführt;
und
eine Verwaltungsvorrichtung, die in Kommunikationsverbindung mit den mehreren Bauteil-Montagemaschinen (10) steht und die Bauteil-Montagestraße verwaltet, wobei die Verwaltungsvorrichtung einschließt:
einen zweiten Abschnitt für Erfassung eines physischen Merkmals, der so ausgeführt ist, dass er ein physisches Merkmal von einer Bedienungsperson erfasst;
einen Abschnitt zum Einstellen von Arbeitsinhalt, der so ausgeführt ist, dass er für die Bedienungsperson, die das durch den zweiten Abschnitt für Erfassung eines physischen Merkmals erfasste physische Merkmal aufweist, Arbeitsinhalt einstellt, der von der Bedienungsperson ausgeführt werden kann; sowie
einen Übertragungsabschnitt, der so ausgeführt ist, dass er Verwaltungsinformationen, die durch den Abschnitt zum Einstellen von Arbeitsinhalt eingestellt werden und in denen das physische Merkmal mit dem ausführbaren Arbeitsinhalt zusammenhängt, zu den mehreren Bauteil-Montagemaschinen (10) überträgt, und
die mehreren Bauteil-Montagemaschinen (10) in dem Abschnitt (34) zum Speichern von Arbeitsinhalt der Bauteil-Montagemaschine (10) gespeicherte Informationen aktualisieren, wenn die Verwaltungsinformationen von dem Übertragungsabschnitt der Verwaltungsvorrichtung empfangen werden.

2. System zum Montieren von Bauteilen nach Anspruch 1, wobei die Verwaltungsvorrichtung des Weiteren einen Abschnitt zum Bestimmen von Verwaltungsinformationen einschließt, der so ausgeführt ist, dass er die durch den Abschnitt zum Einstellen von Arbeitsinhalt eingestellten Verwaltungsinformationen bestätigt, wenn die Verwaltungsinformationen durch eine Verwaltungsperson mit einer bestimmten Autorität eingestellt werden, und die Verwaltungsinformationen nicht bestätigt, wenn die Verwaltungsinformationen durch eine andere Person als die Verwaltungsperson mit der bestimmten Autorität eingestellt werden, und der Übertragungsabschnitt die Verwaltungsinformationen zu den mehreren Bauteil-Montagemaschinen (10) überträgt, wenn durch den Abschnitt zum Bestimmen von Verwaltungsinformationen festgestellt wird, dass die Verwaltungsinformationen gültig sind.

3. System zum Montieren von Bauteilen nach Anspruch 2, wobei die Verwaltungsvorrichtung des Weiteren einen Abschnitt zum Speichern von Verwaltungsinformationen einschließt, der so ausgeführt ist, dass er die Verwaltungsinformationen im Zusammenhang mit der Verwaltungsperson speichert, die die Verwaltungsinformationen eingestellt hat, wenn der Abschnitt zum Bestimmen von Verwaltungsinformationen feststellt, dass die Verwaltungsinformationen gültig sind.

## Revendications

1. Système de montage de composants comprenant une ligne de montage de composants comportant de multiples machines de montage de composant, chacune des multiples machines de montage de composant (10) étant destinée à monter un composant sur une carte, comprenant :
une section de montage de composant (22) configurée pour exécuter un processus de montage consistant à monter le composant électronique sur la carte ;
une section de stockage de contenu de travail (34) configurée pour stocker, pour chaque opérateur, une caractéristique physique acquise auprès de l'opérateur en association avec un contenu de travail exécutable par l'opérateur ;
une première section d'acquisition de caractéristique physique configurée pour acquérir la caractéristique physique auprès de l'opérateur ;
une section de détermination de contenu de travail (44) configurée pour, dans un cas où un travail est effectué sur la section de montage de composant (22) par l'opérateur, valider le travail effectué par l'opérateur lorsque le travail effectué par l'opérateur est stocké dans la section de stockage de contenu de travail (34) en tant que contenu de travail associé à la caractéristique physique de l'opérateur acquise par la première section d'acquisition de caractéristique physique, et invalider le travail effectué par l'opérateur lorsque le travail effectué par l'opérateur n'est pas stocké dans la section de stockage de contenu de travail (34) en tant que contenu de travail associé à la caractéristique physique de l'opérateur acquise par la première section d'acquisition de caractéristique physique, dans lequel
la section de stockage de contenu de travail (34) stocke, comme étant exécutable, un travail d'établissement destiné à établir des conditions de fonctionnement du processus de montage à exécuter par la section de montage de composant (22) en association avec une caractéristique physique acquise auprès d'un opérateur spécifique, et la section de détermination de contenu de travail (44) valide le travail d'établissement lorsque le travail d'établissement est effectué par l'opérateur spécifié et invalide le travail d'établissement lorsqu'une personne autre que l'opérateur spécifié effectue le travail d'établissement ; et
un dispositif de gestion connecté en communication aux multiples machines de montage de composant (10) et gérant la ligne de montage de composants, dans lequel le dispositif de gestion comporte
une seconde section d'acquisition de caractéristique physique configurée pour acquérir une caractéristique physique auprès d'un opérateur ;
une section d'établissement de contenu de travail configurée pour établir, pour l'opérateur ayant la caractéristique physique acquise par la seconde section d'acquisition de caractéristique physique, un contenu de travail exécutable par l'opérateur ; et
une section de transmission configurée pour transmettre des informations de gestion, qui sont établies par la section d'établissement de contenu de travail et dans lesquelles la caractéristique physique est associée au contenu de travail exécutable, aux multiples machines de montage de composant (10), et
les multiples machines de montage de composant (10) mettent à jour des informations stockées dans la section de stockage de contenu de travail (34) de la machine de montage de composant (10) lorsque les informations de gestion sont reçues de la section de transmission du dispositif de gestion.

2. Système de montage de composants selon la revendication 1, dans lequel le dispositif de gestion comporte en outre une section de détermination d'informations de gestion configurée pour valider les informations de gestion établies par la section d'établissement de contenu de travail lorsque les informations de gestion sont établies par un gestionnaire ayant une autorité spécifique, et invalider les informations de gestion lorsque les informations de gestion sont établies par une personne autre que le gestionnaire ayant l'autorité spécifique, et la section de transmission transmet les informations de gestion aux multiples machines de montage de composant (10) lorsque les informations de gestion sont déterminées comme étant valides par la section de détermination d'informations de gestion.

3. Système de montage de composants selon la revendication 2, dans lequel le dispositif de gestion comporte en outre une section de stockage d'informations de gestion configurée pour stocker les informations de gestion en association avec le gestionnaire qui a établi les informations de gestion lorsque la section de détermination d'informations de gestion détermine que les informations de gestion sont valides.
